# FASCICULE DE BREVET EUROPEEN

(11) **EP 0 493 185 B1**
(45) Date de publication et mention de la délivrance du brevet: **20.11.1996**
(21) Numéro de dépôt: 91403409.5
(22) Date de dépôt: 16.12.1991
(51) Int. Cl.: H03K 17/16, H03K 17/08

(54) **Circuit de commande d'un transistor de puissance utilisé en commutation forcée**
Steuerschaltung für einen zwangskommutierten Leistungstransistor
Control circuit for a force commutated power transistor

(30) Priorité: 27.12.1990 FR 9016353
(43) Date de publication de la demande: 01.07.1992
(73) Titulaire: AUTOMOBILES PEUGEOT, 75116 Paris (FR); AUTOMOBILES CITROEN, 92200 Neuilly-sur-Seine (FR)
(72) Inventeur: Berry, Jean-Paul, F-31520 Ramonville St Agne (FR)
(74) Mandataire: Moncheny, Michel

(56) Documents cités:
- EP-A- 0 278 432
- WO-A-88/08228
- GB-A- 2 140 996
- ELECTRONICS, vol. 49, no. 13, 24 juin 1976, pages 98-103; M. VAN DER KOOI et al.: "MOS moves into higher-power applications"

## Description

La présente invention concerne les transistors de puissance qui sont utilisés en commutation forcée de manière à réaliser un interrupteur commandé ; c'est le cas en particulier des transistors utilisés dans les convertisseurs continu-continu (hâcheurs), en commande de moteurs continus et dans les convertisseurs continu-alternatif (ponts, onduleurs de tension), en commande de moteurs alternatifs synchrones ou asynchrones.

L'invention s'applique plus particulièrement aux transistors de type MOS à effet de champ, en abrégé MOSFET, qui, lorsqu'ils sont utilisés en commutation forcée sans prendre de précautions (résistance interne de la source de tension de charge de porte faible, absence de circuit d'aide à la commutation dans le drain) présentent, du fait de leur rapidité, des gradients de tension et de courant très élevés dans leur circuit de drain.

Ces gradients élevés sont dangereux ; en effet, tout d'abord, un gradient de tension positif peut entraîner une avalanche ; de plus, le gradient de courant augmente localement la densité de courant, mais surtout fait apparaître des surtensions aux bornes des inductances parasites.

A côté du problème de la sécurité de fonctionnement, il existe le problème des parasites émis ; ce problème est particulièrement important dans le cas où les circuits de puissance et les circuits de commande à bas niveau d'un dispositif électronique sont rapprochés, en particulier dans le cas où l'on réalise des circuits hybrides ou même des circuits intégrés.

On peut bien évidemment protéger les circuits électroniques de commande à bas niveau par exemple en utilisant des anneaux de garde ou la polarisation du substrat, mais il est préférable de réduire les bruits ou les rayonnements électromagnétiques là où ils sont créés, c'est-à-dire au niveau des composants de puissance.

Il existe déjà des dispositifs de protection fonctionnant en boucle ouverte et comportant par exemple des éléments passifs tels que des inductances, des résistances ou des condensateurs branchés dans le circuit commuté par le transistor de puissance.

Dans le cas d'un transistor de type MOS à effet de champ, on peut obtenir un certain contrôle de la commutation par le régime de charge de la porte. Divers circuits de charge permettent d'éviter l'usage de circuits passifs d'aide à la commutation, voir l'ouvrage de Duncan A. GRANT et John GONAR "Power Mosfets Theory and Applications" pages 191-195 et pages 289-292 publié par John WILEY and Sons ; ils permettent un réglage en boucle ouverte des gradients de tension et de courant dans certaines phases critiques.

Par exemple, pendant le recouvrement des charges stockées dans une diode de roue libre, on augmente la résistance de porte.

Il y a un inconvénient à maintenir une résistance de porte élevée lors de la variation de la tension du drain à cause de l'effet MILLER. Aussi on cherche à faire varier automatiquement la résistance de porte en fonction de la séquence de commutation forcée dans laquelle on se trouve, comme indiqué dans l'article de J.P. BERRY "Pour se rapprocher du commutateur idéal : naissance du concept MOS-BIPMOS paru dans la revue "Electronique de Puissance" n°3 de février 1984.

Une autre solution est décrite dans l'article de J. HARDEN "The Si 9910 Adaptive Power MOSFET driver improve performance in high voltage half bridge applications" note d'application SILICONIX AN89-5 de juillet 1989 pages 27-36 qui décrit un circuit intégré de commande possédant des facultés d'adaptation.

Ces circuits d'aide passifs et/ou actifs pour agir dans différentes phases de commutations augmentent la complexité du montage de puissance. Leur efficacité est limitée évidemment aux séquences pour lesquelles ils sont conçus.

Par exemple la variation en gradient de tension lors du blocage par accroissement de la résistance de porte ne protège pas le transistor MOSFET des forts gradients de tension engendrés par la charge elle-même.

Il faut donc envisager la surveillance de la tension du drain et un rebouclage par remise en conduction du dispositif.

Il existe également un phénomène rayonnant moins connu qui est constitué par une instabilité "petit signal" ou mode de réponse sinusoïdal amorti apparaissant dans l'état transitoire pendant lequel la transconductance du MOSFET est grande.

Lors de la mise en conduction et lors du blocage, il y a une émission de trains d'onde sinusoïdale amortie à quelques dizaines de mégahertz pendant une dizaine de microsecondes, comme cela est décrit dans l'article de D. GIANDOMENICO, D. SON KUO, CHENMING HU and JEONG CHOI "Analysis and Prevention of Power MOSFET anomalous oscillations" paru dans "Proceedings of Powercon" de novembre 1984 et de H. KUYEN, D. BAERT "Determination of the power losses in a 1 KVA Pulse With Modulated Inverter" paru dans "Proceedings of EPE" du 22-24 septembre 1987 pages 111-116.

Par exemple, sur un transistor MOSFET utilisé comme hâcheur, lors de l'état de commutation transitoire, c'est-à-dire entre la conduction et le blocage, la transconductance étant définie, il se produit des oscillations dont la fréquence est de 18 Mhz avec un coefficient d'amortissement égal à 0,045 ; ces valeurs expérimentales correspondent aux valeurs que l'on peut obtenir par le calcul.

La présente invention se propose de fournir un circuit de commande d'un transistor de puissance utilisé en commutation forcée qui permet d'obtenir une sécurité de fonctionnement et également d'éliminer les rayonnements parasites de manière efficace avec un montage simple.

L'invention a pour objet un circuit de commande d'un transistor de puissance utilisé en commutation forcée, en particulier d'un transistor du type MOS à effet de champ, comportant un circuit d'attaque de la porte dudit transistor commandé par un signal de commande, ledit circuit d'attaque étant également commandé par deux signaux de contre-réaction, un signal proportionnel au gradient de la tension aux bornes du transistor et un signal proportionnel au gradient du courant principal du transistor.

On réalise ainsi un contrôle des gradients de tension et de courant en boucle fermée, les dispositifs correcteurs se trouvant en parallèle sur le transistor de puissance. Le circuit de commande comporte un circuit intégrateur alimenté par le signal proportionnel au gradient de courant et un comparateur comparant la valeur du courant instantané fourni par ledit intégrateur à une valeur de seuil correspondant au courant maximal admissible du transistor, ledit comparateur commandant le blocage dudit transistor lorsque la valeur du courant instantané atteint ladite valeur de seuil.

Selon un mode de réalisation, le circuit de commande du transistor de puissance comporte une résistance en série dans le circuit principal du transistor et un circuit différentiateur est branché aux bornes de ladite résistance série et relié au circuit d'attaque.

Selon un autre mode de réalisation, le circuit de commande du transistor de puissance comporte une inductance branchée en série dans le circuit principal du transistor et dont la tension est appliquée au circuit d'attaque.

Avantageusement, ladite inductance est constituée par un conducteur d'environ 1 cm de longueur et 0,5 mm de diamètre.

Selon une variante de réalisation, le circuit de commande est réalisé en technique intégrée et l'inductance est constituée par l'inductance parasite interne du transistor.

Selon une autre caractéristique de l'invention, le circuit de commande comporte un étage amplificateur du gradient de courant qui est avantageusement constitué par deux circuits miroirs de courant amplifiant respectivement les variations positives et négatives du gradient de courant.

Selon encore une autre caractéristique de l'invention, le signal de sortie de l'étage amplificateur est appliqué au circuit d'attaque par l'intermédiaire d'un circuit convoyeur de courant.

Selon encore une autre caractéristique de l'invention, le circuit d'attaque est un circuit d'attaque à sortie en totem.

L'invention sera mieux comprise à l'aide de la description qui va suivre, donnée uniquement à titre d'exemple et faite en se référant aux dessins annexés sur lesquels :
- les figures 1 et 2 sont des schémas de principe de deux modes de réalisation de l'invention ;
- les figures 3 et 4 sont des schémas de réalisation correspondant aux figures 1 et 2 l'intégrateur et le comparateur selon l'invention n'étant pas représentés ;
- les figures 5A à 5D sont des diagrammes de fonctionnement d'un transistor de puissance à commande classique ;
- les figures 6A à 6D sont des diagrammes correspondants pour le même transistor avec un circuit de commande conforme à la présente invention ; et
- les figures 7 et 8 illustrent un autre mode de réalisation de l'invention.

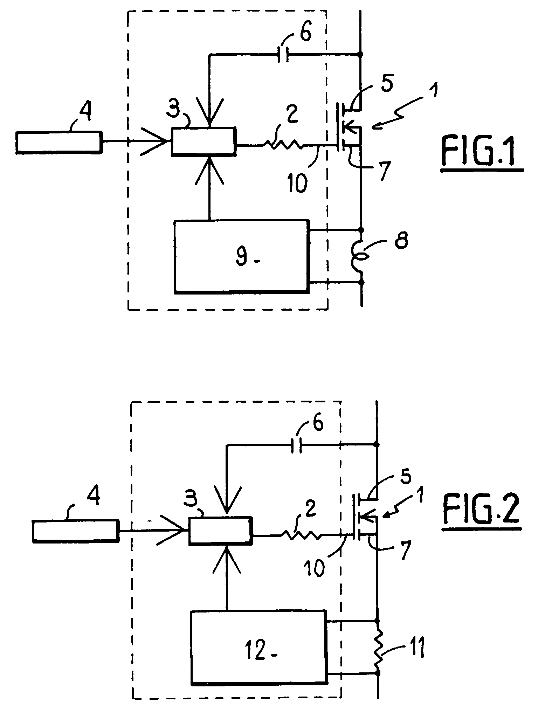

Les figures 1 et 2 illustrent le principe de l'invention ; sur ces deux figures on peut voir un transistor de puissance utilisé en commutation forcée, par exemple un transistor de type MOS à effet de champ 1. Un tel transistor peut être utilisé dans le circuit de commande d'un moteur à courant continu ou alternatif d'un véhicule automobile. La porte 10 de ce transistor de puissance 1 est commandée, par l'intermédiaire d'une résistance de charge 2 par un circuit d'attaque 3 qui reçoit un signal de commande extérieur 4 qui peut prendre deux valeurs, une première valeur pour laquelle le transistor MOSFET 1 est bloqué et une deuxième valeur pour laquelle le transistor MOSFET 1 est à l'état conducteur.

Conformément à la présente invention, le circuit d'attaque 3 est également commandé par deux signaux de contre-réaction, un signal de contre-réaction proportionnel au gradient de tension sur une de ses bornes, le drain 5 dans l'exemple représenté et un signal proportionnel au gradient de courant dans le circuit principal du transistor, c'est-à-dire le circuit commandé par ledit transistor.

Le gradient de tension peut par exemple être fourni par un condensateur 6 branché entre le drain 5 et le circuit d'attaque 3.

Le signal proportionnel au gradient de courant est prélevé dans le circuit de la source 7 du transistor 1. Dans un premier mode de réalisation représenté sur la figure 1, on dispose une inductance série 8 dans le circuit de source du transistor 1 et on prélève la tension aux bornes de cette inductance ; cette tension est amplifiée dans un circuit d'amplification 9.

Dans un second mode de réalisation, on dispose une résistance 11 en série dans le circuit de source du transistor 1 et la tension prélevée aux bornes de cette résistance 11 est envoyée dans un circuit différentiateur 12 qui peut également comporter un étage amplificateur.

On voit donc que l'on réalise une commande en boucle fermée du gradient de la tension aux bornes du drain du transistor et du gradient du courant source du transistor 1. De cette manière, on peut régler précisément et donc limiter les vitesses de variation de la tension de drain et du courant de source du transistor 1. Ceci permet d'obtenir une sécurité de fonctionnement du transistor lors de la commutation et, par ailleurs, le rayonnement parasite du transistor de puissance est également fortement réduit.

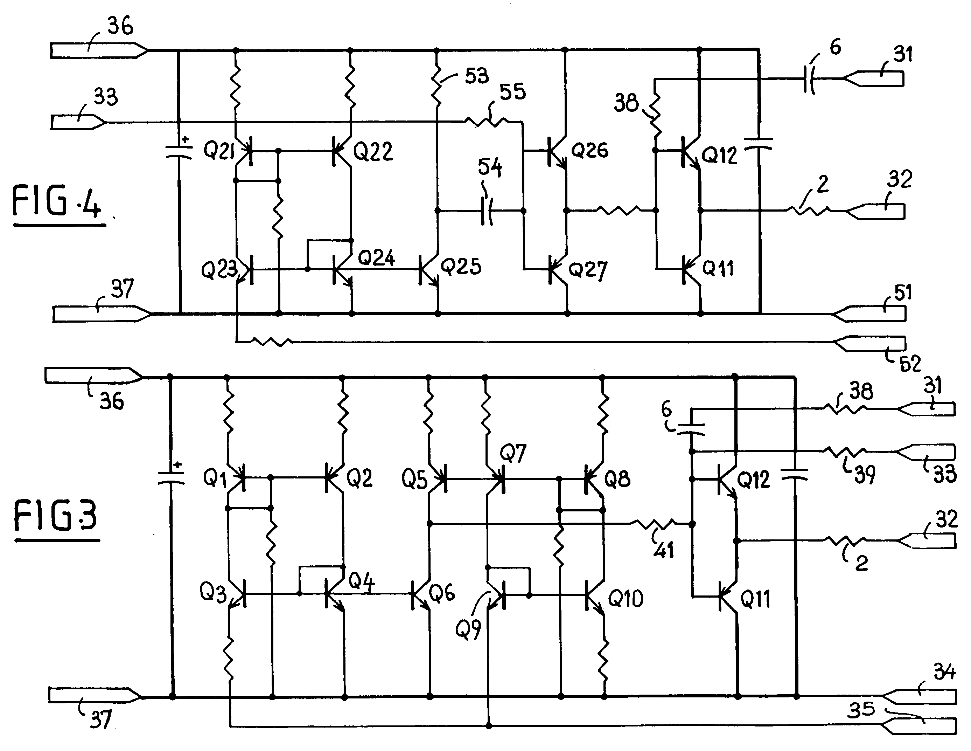

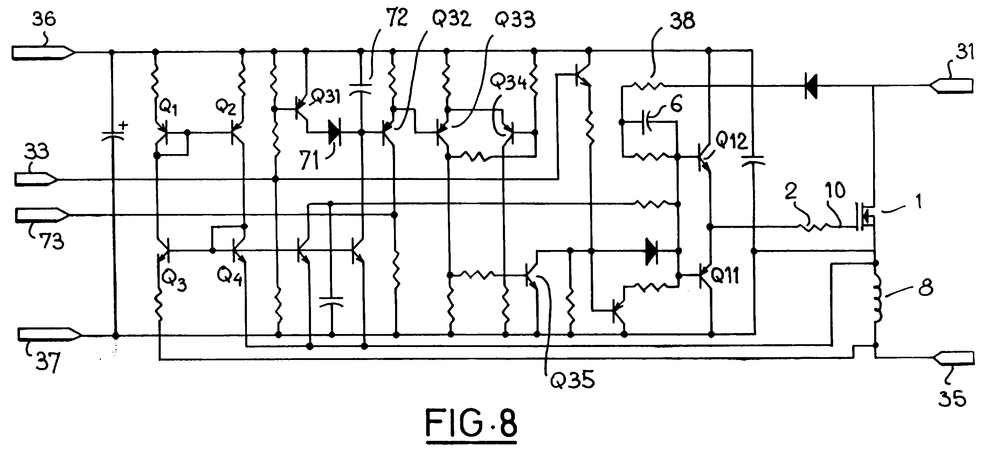

La figure 3 est le schéma d'un premier mode de réalisation du circuit de commande correspondant au schéma général de la figure 1. Sur cette figure, on a simplement représenté le circuit de commande, l'intégrateur (voir la figure 8: Q31, 71,72) le comparateur (voir la figure 8: Q33, Q34), le transistor 1 et l'inductance 8 n'étant pas représentés. Les bornes 31 et 32 sont reliées respectivement au drain et à la porte du transistor 1. La borne 33 reçoit le signal de commande extérieur ; les bornes 34 et 35 sont reliées à l'inductance 8 et les bornes 36 et 37 sont reliées respectivement aux bornes positive et négative d'une tension d'alimentation.

La tension aux bornes du drain 5 du transistor est prélevée par le condensateur 6 en série avec une résistance 38 et appliquée à l'entrée du circuit d'attaque qui est constitué par un circuit à sortie en totem constitué de deux transistors bipolaires de types opposés Q12 et Q11 qui sont branchés en série aux bornes de la tension d'alimentation 36 et 37 et dont les bases sont reliées entre elles. Ce circuit de type totem reçoit également sur son entrée, qui est reliée aux bases des deux transistors Q12 et Q11, le signal de commande appliqué à la borne 33 par l'intermédiaire d'une résistance 39.

La tension prélevée sur les bornes 34 et 35 de l'inductance 8 est envoyée sur un étage amplificateur qui est constitué de deux circuits miroirs de courant, le premier amplifiant les variations positives du courant et le second les variations négatives. Le circuit miroir de courant pour le gradient positif est constitué des transistors bipolaires de mêmes caractéristiques Q1 Q2 Q3 Q4. Le circuit miroir de courant pour le gradient négatif est constitué des transistors bipolaires de mêmes caractéristiques Q7 Q8 Q9 Q10.

La sortie de chacun des deux circuits miroirs de courant est envoyée sur la base d'un transistor Q5, respectivement Q6 constituant un convoyeur de courant ; ces deux transistors Q5 et Q6 sont des transistors bipolaires de types opposés et sont branchés en série entre les deux bornes 36 et 37 de la source d'alimentation, les deux collecteurs constituant la sortie des deux convoyeurs de courant étant reliés entre eux. Cette sortie commune est envoyée à l'entrée du circuit d'attaque Q11-Q12 par l'intermédiaire d'une résistance 41.

La figure 4 représente un mode de réalisation du circuit de commande correspondant au schéma de principe de la figure 2. On retrouve sur cette figure les bornes 31 à 32, 36 et 37, le condensateur 6 et la résistance 38; le circuit d'attaque est le même circuit que le circuit totem de la figure 3 et est constitué des transistors Q12 et Q11. L'intégrateur (voir la figure 8: Q31, 71, 72) et le comparateur (voir la figure 8: Q33, Q34) selon l'invention ne sont pas représentés dans la figure 4.

Dans ce mode de réalisatlon, les deux bornes 51 et 52 sont reliées à la résistance 11 de la figure 2. La tension positive prélevée aux bornes de la résistance 11 est amplifiée par un circuit miroir de courant constitué par les transistors Q21 à Q24 et dont la sortie est envoyée sur un circuit convoyeur de courant constitué par le transistor bipolaire Q25 qui comporte une résistance de charge 53.

La tension récoltée sur le collecteur du transistor Q25 est envoyée sur un circuit différentiateur constitué par un condensateur 54 et une résistance 55 qui sont reliés à la base de deux transistors bipolaires de types opposés Q26 et Q27 montés en série entre les deux bornes 36 et 37 de l'alimentation et dont les émetteurs d'une part et les bases d'autre part sont reliés respectivement entre eux. Le circuit différentiateur constitué par la résistance 55 et le condensateur 54 est branché sur la base commune des deux transistors Q26 et Q27. Le signal de commande extérieur provenant de la borne 33 est également envoyé sur la base commune des transistors Q26 et Q27 par l'intermédiaire de la résistance 55. Le signal de sortie prélevé sur les émetteurs des transistors Q26 et Q27 est envoyé sur l'entrée du circuit en totem constitué par les transistors Q12 et Q11.

Dans ce dernier mode de réalisation, la différentiation étant réalisée après l'amplification, on n'utilise qu'un seul circuit miroir de courant en tant qu'amplificateur.

Le condensateur 6 de prélèvement de la tension de drain est de très faible valeur, de l'ordre de quelques picofarads ; il en est de même pour l'inductance 8 qui permet d'obtenir directement le gradient de courant de source et qui a une valeur égale à quelques nanohenrys. Cette inductance peut par exemple être réalisée au moyen d'un conducteur dont la longueur est d'environ 1 cm dont la section est d'environ 0,5 mm de diamètre. Cette inductance peut également être constituée par la connexion interne de l'électrode source du transistor MOSFET dans le cas d'une réalisation en circuit hybride ou intégré.

Dans le cas où l'on utilise le montage des figures 2 et 4 avec une résistance en série dans le circuit de source, il faut utiliser une résistance qui soit aussi peu inductive que possible et qui présente un faible effet de peau.

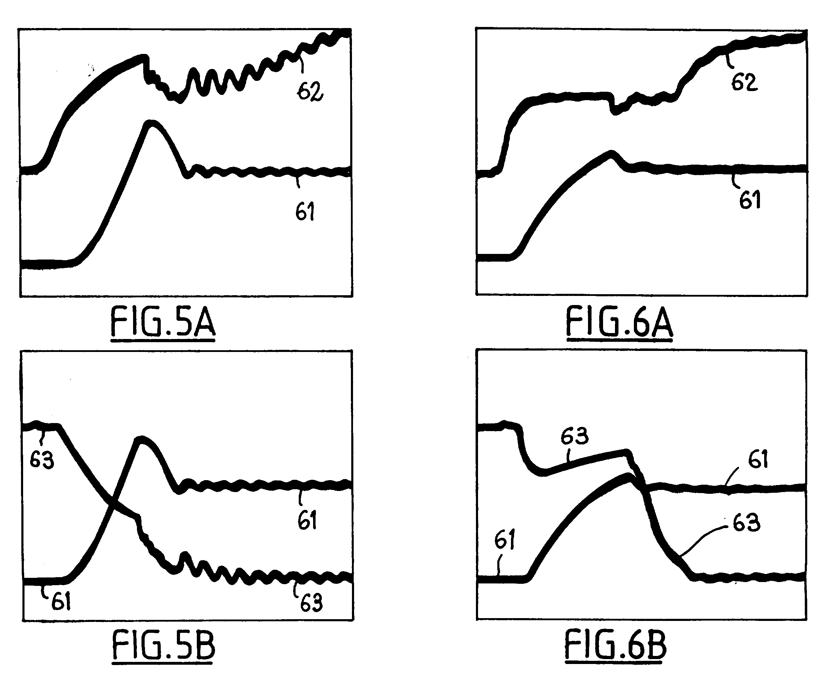

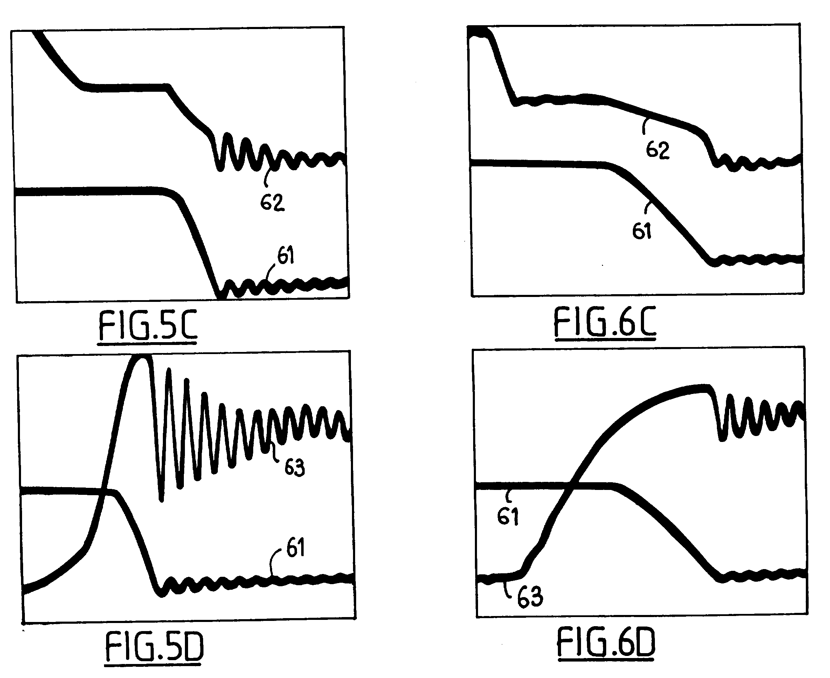

Les résultats obtenus grâce à la commande selon l'invention sont illustrés par l'ensemble des figures 5 et 6 qui représentent des courbes relevées sur un oscilloscope. Les figures A et B correspondent à la mise en conduction du transistor MOSFET 1 et les figures C et D correspondent au blocage de ce transistor. Sur les figures A et B on voit le courant de drain (courbe 61), la tension de porte (courbe 62 de la figure A) et la tension de drain (courbe 63 de la figure B). Sur les figures C et D on a représenté les mêmes paramètres dont les courbes sont repérées par les mêmes références numériques.

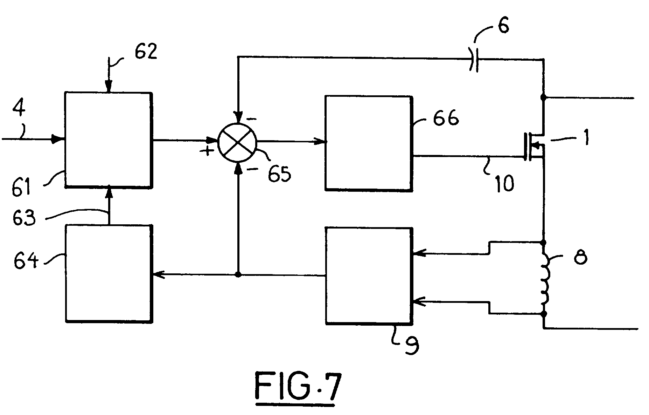

La figure 7 est un schéma de principe et la figure 8 un schéma de réalisation d'un autre mode de réalisation de l'invention qui comporte un circuit intégrateur.

La figure 7 correspond pour l'essentiel à la figure 1 ; le signal de commande extérieur 4 est envoyé sur un circuit de déclenchement 61 qui reçoit par ailleurs un signal de référence 62 représentatif de l'intensité maximale que peut supporter le transistor 1, Imax. Par ailleurs ce circuit de déclenchement reçoit un signal 63 représentatif de la valeur instantanée du courant traversant le transistor 1. Cette valeur instantanée est fournie par un circuit intégrateur 64 qui reçoit le signal de sortie de l'amplificateur 9 du gradient de courant fourni par l'inductance série 8.

Le circuit d'attaque commandant la porte 10 du transistor de puissance 1 est constitué d'un comparateur 65 qui reçoit le signal de sortie du circuit déclencheur 61 et les deux signaux de contre-réaction de gradient de tension et de gradient de courant et d'un étage d'amplification 66.

La figure 8 correspond à la figure 3 et on y retrouve certains composants de cette figure.

Le circuit intégrateur est constitué par le transistor Q31, la diode 71 et le condensateur 72 ; ce circuit intégrateur est remis à zéro pour chaque cycle par le signal de commande fourni par la borne 33.

La sortie de ce circuit intégrateur est envoyée sur la base d'un transistor Q32 qui fournit un signal représentatif de la valeur instantanée du courant tranversant le transistor de puissance 1 ; cette valeur peut être prélevée par une borne 73, par exemple pour réaliser une surveillance du fonctionnement du transistor.

Deux transistors Q33 et Q34 constituent un détecteur de seuil qui comparent un signal correspondant au courant instantané à une valeur de seuil correspondant à l'intensité maximale admise et, lorsque le courant instantané dépasse cette valeur, la commande de la porte 10 du transistor de puissance 1 est supprimée par l'intermédiaire du transistor Q35.

De cette manière on peut surveiller la valeur de crête du courant traversant le transistor de puissance 1 et bloquer ce dernier dès que la valeur instantanée du courant du transistor atteint la valeur maximale admissible précitée Imax.

On s'aperçoit que l'invention permet de stabiliser le fonctionnement du transistor, et en particulier d'amortir très fortement les oscillations parasites, ce qui permet de réduire très fortement le rayonnement parasite du transistor de puissance. On peut alors l'utiliser dans des circuits hybrides ou des circuits intégrés à proximité de circuits de commandes de faible puissance sans risque de perturbations de ces derniers pour lesquels 11 n'est plus besoin de prévoir de circuits de protection.

Plus particulièrement, on peut noter lors de la mise en conduction une réduction du courant de crête et une décroissance plus rapide de la tension de drain. En ce qui concerne le blocage, on peut constater également une croissance plus rapide de la tension de drain.

Ces résultats sont liés à l'utilisation des circuits miroirs de courant, convoyeurs de courant et totems qui sont des circuits rapides qui peuvent être facilement réalisés en technique intégrée.

Lors de l'expérimentation de l'invention, on a également constaté, pour une fréquence de commutation de 20 kHz une diminution de la perte de puissance lors de la mise en conduction, cette perte de puissance passant de 3,6 à 2,9 W. Ce dernier résultat est dû en particulier au fait que l'invention permet d'utiliser une résistance de porte de très faible valeur.

Pour améliorer les performances des circuits selon l'invention, il est avantageux de travailler avec des transistors rapides dont la fréquence de transition est supérieure à 1 GHz.

L'invention présente un avantage supplémentaire en ce sens que la limitation des gradients de courant permet de minimiser la taille d'un composant quine peut être réalisé par la technique des circuits intégrés et qui est coûteux, à savoir le condensateur de découplage.

L'invention permet de réaliser l'asservissement du gradient du courant tranversant le transistor de puissance ; il est donc possible, par intégration, de reconstituer le courant instantané à condition de travailler avec une commande périodique dont la fréquence est suffisamment élevée pour pouvoir remettre à zéro le circuit intégrateur à chaque cycle. Il est ainsi possible d'effectuer une mesure du courant instantané et une surveillance du courant de crête. Ceci permet de réaliser une protection très efficace des transistors de puissance, par exemple en cas de court-circuit.

## Revendications

1. Circuit de commande d'un transistor de puissance (1) utilisé en commutation forcée, en particulier d'un transistor du type MOS à effet de champ, comportant des moyens (6) de génération d'un signal proportionnel au gradient de la tension aux bornes du transistor (1), des moyens (8,11,12;54,55) de génération d'un signal proportionnel au gradient du courant principal du transistor (1) et un circuit d'attaque (3) de la porte (10) du transistor (1), ledit circuit d'attaque (3) étant commandé par un signal de commande (4,33), le signal proportionnel au gradient de la tension et le signal proportionnel au gradient du courant principal du transistor (1), caractérisé en ce qu'il comporte un circuit intégrateur (64;Q31,71,72) alimenté par le signal proportionnel au gradient de courant et un comparateur (Q33,Q34) comparant la valeur du courant instantané fourni par ledit intégrateur (64;Q31,71,72) à une valeur de seuil correspondant au courant maximal admissible du transistor, ledit comparateur commandant le blocage dudit transistor (1) lorsque la valeur du courant instantané atteint ladite valeur de seuil.

2. Circuit de commande d'un transistor de puissance selon la revendication 1, caractérisé en ce que les moyens de génération du signal proportionnel au gradient de courant comportent une résistance (11) en série dans le circuit principal du transistor (1) et en ce qu'un circuit différentiateur (12;54,55) est branché aux bornes de ladite résistance série et relié au circuit d'attaque.

3. Circuit de commande d'un transistor de puissance selon la revendication 1, caractérisé en ce que les moyens de génération du signal proportionnel au gradient de courant comportent une inductance (8) branchée en série dans le circuit principal du transistor et dont la tension est appliquée au circuit d'attaque (3).

4. Circuit de commande d'un transistor de puissance selon la revendication 3, caractérisé en ce que ladite inductance (8) est constituée par un conducteur d'environ 1 cm de longueur et 0,5 mm de diamètre.

5. Circuit de commande d'un transistor de puissance selon la revendication 3, caractérisé en ce que le circuit de commande est réalisé en technique intégrée et en ce que l'inductance (8) est constituée par l'inductance parasite interne du transistor.

6. Circuit de commande d'un transistor de puissance selon l'une quelconque des revendications 1 à 5, caractérisé en ce que les moyens de génération de signaux proportionnels au gradient de tension comportent un condensateur (6) branché entre une des électrodes principales (5) du transistor et le circuit d'attaque (3).

7. Circuit de commande d'un transistor de puissance selon l'une quelconque des revendications 1 à 6, caractérisé en ce qu'il comporte un étage amplificateur du gradient de courant (Q1-Q4,Q7-Q10;Q21-Q24).

8. Circuit de commande d'un transistor de puissance selon la revendication 7, caractérisé en ce que ledit étage amplificateur est constitué par deux circuits miroirs de courant (Q1-Q4,Q7-Q10) amplifiant respectivement les variations positives et négatives du gradient de courant.

9. Circuit de commande d'un transistor de puissance selon la revendication 7 ou 8, caractérisé en ce que le signal de sortie de l'étage amplificateur est appliqué au circuit d'attaque par l'intermédiaire d'un circuit convoyeur de courant (Q5,Q6;Q25).

10. Circuit de commande d'un transistor de puissance selon l'une quelconque des revendications 1 à 9, caractérisé en ce que le circuit d'attaque (3) est un circuit d'attaque à sortie en totem (Q11,Q12).

## Patentansprüche

1. Steuerschaltung für einen zwangskommutierten Leistungstransistor (1), insbesondere für einen Feldeffekt-MOS-Transistor, umfassend eine Einrichtung (6) zum Erzeugen eines Signals, das proportional zum Spannungsgradienten an den Klemmen des Transistors (1) ist, eine Einrichtung (8, 11, 12; 54, 55) zur Erzeugung eines Signals, das proportional zum Hauptstromgradienten des Transistors (1) ist, und einen Treiberkreis (3) für das Steuertor (10) des Transistors (1), wobei der Treiberkreis (3) durch ein Steuersignal (4, 33), das zum Spannungsgradienten proportionale Signal und das zum Hauptstromgradienten des Transistors (1) proportionale Signal gesteuert ist, dadurch gekennzeichnet, daß sie eine Integrierschaltung (64; Q31, 71, 72) aufweist, die durch das zum Stromgradienten proportionale Signal gespeist ist, und einen Komparator (Q33, Q34), der dem Wert des Momentanstroms, der durch die Integrierschaltung (64; Q31, 71, 72) geliefert wird, mit einem Schwellenwert vergleicht, der einem maximal zulässigen Strom des Transistors entspricht, wobei der Komparator die Blockierung des Transistors (1) befiehlt, wenn der Wert des Momentanstroms den Schwellenwert erreicht.

2. Steuerschaltung für einen Leistungstransistor nach Anspruch 1, dadurch gekennzeichnet, daß die Einrichtung zur Erzeugung des zum Stromgradienten proportionalen Signals einen Widerstand (11) in Reihe in dem Hauptkreis des Transistors (1) aufweist, und daß eine Differenzierschaltung (12; 54, 55) an die Klemmen des Reihenwiderstands angeschlossen und mit dem Treiberkreis verbunden ist.

3. Steuerschaltung für einen Leistungstransistor nach Anspruch 1, dadurch gekennzeichnet, daß die Einrichtung zur Erzeugung des zum Stromgradienten proportionalen Signals eine Induktanz (8) aufweist, die in den Transistorhauptkreis in Reihe geschaltet ist, und deren Spannung an den Treiberkreis (3) angelegt ist.

4. Steuerschaltung für einen Leistungstransistor nach Anspruch 3, dadurch gekennzeichnet, daß die Induktanz (8) durch einen Leiter mit einer Dicke von ungefähr 1 cm und einem Durchmesser von 0,5 mm gebildet ist.

5. Steuerschaltung für einen Leistungstransistor nach Anspruch 3, dadurch gekennzeichnet, daß die Steuerschaltung in integrierter Technik verwirklicht ist, und daß die Induktanz (8) durch die parasitäre Inneninduktanz des Transistors gebildet ist.

6. Steuerschaltung für einen Leistungstransistor nach einem der Ansprüche 1 bis 5, dadurch gekennzeichnet, daß die Einrichtung zur Erzeugung der zum Spannungsgradienten proportionalen Signale einen Kondensator (6) aufweist, der zwischen eine der Hauptelektroden (5) des Transistors und den Steuerkreis (3) geschaltet ist.

7. Steuerschaltung für einen Leistungstransistor nach einem der Ansprüche 1 bis 6, dadurch gekennzeichnet, daß sie eine Verstärkerstufe (Q1-Q4, Q7-Q10; Q21-Q24) für den Stromgradienten aufweist.

8. Steuerschaltung für einen Leistungstransistor nach Anspruch 7, dadurch gekennzeichnet, daß die Verstärkerstufe durch zwei Stromspiegelschaltungen (Q1-Q4, Q7-Q10) gebildet ist, die jeweils die positiven und negativen Änderungen des Stromgradienten verstärken.

9. Steuerschaltung für einen Leistungstransistor nach Anspruch 7 oder 8, dadurch gekennzeichnet, daß das Ausgangssignal der Verstärkerstufe an den Treiberkreis unter Zwischenschaltung einer Stromlieferschaltung (Q5, Q6; Q25) angelegt ist.

10. Steuerschaltung für einen Leistungstransistor nach einem der Ansprüche 1 bis 9, dadurch gekennzeichnet, daß die Treiberschaltung (3) eine Treiberschaltung mit Totempfahlausgang (Q11, Q12) ist.

## Claims

1. Control circuit for a power transistor (1) used in forced switching mode, in particular for an MOS field effect transistor, comprising means (6) of generating a signal proportional to the voltage gradient at the terminals of the transistor (1), means (8, 11, 12; 54, 55) of generating a signal proportional to the principal current gradient of the transistor (1) and a drive circuit (3) for the gate (10) of the transistor (1), the said drive circuit (3) being controlled by a control signal (4, 33), the signal proportional to the voltage gradient and the signal proportional to the principal current gradient of the transistor (1), characterized in that it comprises an integrator circuit (64;Q31, 71, 72) fed by the signal proportional to the current gradient and a comparator (Q33, Q34) comparing the value of the instantaneous current supplied by the said integrator (64;Q31, 71, 72) with a threshold value corresponding to the maximum admissible current of the transistor, the said comparator controlling the cutting off of the said transistor (1) when the value of the instantaneous current reaches the said threshold value.

2. Control circuit for a power transistor according to Claim 1, characterized in that the means of generating a signal proportional to the current gradient comprise a resistor (11) in series in the principal circuit of the transistor (1) and in that a differentiator circuit (12;54,55) is connected to the terminals of the said series resistor and is connected to the drive circuit.

3. Control circuit for a power transistor according to Claim 1, characterized in that the means of generating a signal proportional to the current gradient comprise an inductance (8) connected in series in the principal circuit of the transistor and whose voltage is applied to the drive circuit (3).

4. Control circuit for a power transistor according to Claim 3, characterized in that the said inductance (8) consists of a conductor having a length of about 1 cm and a diameter of about 0.5 mm.

5. Control circuit for a power transistor according to Claim 3, characterized in that the control circuit is produced using the integrated technique and in that the inductance (8) consists of the internal stray inductance of the transistor.

6. Control circuit for a power transistor according to any one of Claims 1 to 5, characterized in that the means of generating signals proportional to the voltage gradient comprise a capacitor (6) connected between one of the principal electrodes (5) of the transistor and the drive circuit (3).

7. Control circuit for a power transistor according to any one of Claims 1 to 6, characterized in that it comprises a current gradient amplifier stage (Q1-Q4, Q7-Q10; Q21-Q24).

8. Control circuit for a power transistor according to Claim 7, characterized in that the said amplifier stage consists of two current mirror circuits (Q1-Q4, Q7-Q10) respectively amplifying the positive and negative variations of the current gradient.

9. Control circuit for a power transistor according to Claim 7 or 8, characterized in that the output signal of the amplifier stage is applied to the drive circuit by the intermediary of a current conveyor circuit (Q5,Q6; Q25).

10. Control circuit for a power transistor according to any one of Claims 1 to 9, characterized in that the drive circuit (3) is a drive circuit with a "totem pole connection" output (Q11,Q12).
